# EUROPEAN PATENT APPLICATION

(11) **EP 4 379 723 A1**
(43) Date of publication of application: **05.06.2024**
(21) Application number: 23212817.3
(22) Date of filing: 28.11.2023
(51) Int. Cl.: G11C 16/16, G11C 16/34, G06F 12/02

(54) **NON-VOLATILE MEMORY**

(30) Priority: 30.11.2022 FR 2212578
(71) Applicant: STMicroelectronics (Rousset) SAS, 13790 Rousset (FR)
(72) Inventor: ARNAL, Christophe, 06460 SAINT VALLIER DE THIEY (FR)
(74) Representative: Thibon, Laurent

(57) **Abstract**

The present disclosure concerns a non-volatile memory comprising a plurality of current memory sectors (S1, S2), a substitution memory sector (S3), and a circuit for controlling the non-volatile memory configured to store data into the sectors and to erase data stored in one of the sectors by erasing all the data stored in said sector at once; a first current memory sector comprising at least one first valid data element (D1_0) and a second current sector comprising at least one second valid data element (D2_0); the memory control circuit being configured to determine that one of the current sectors is to be erased, and accordingly select one sector from among the current sectors; copy the valid data of the selected current sector into the substitution memory sector; and erase all the data of the selected current sector.

## Description

### Technical background

The present disclosure generally concerns non-volatile memories and particularly FLASH-type memories.

### Prior art

It has been proposed to emulate an electrically erasable programmable read-only memory (EEPROM), or any other memory of low access granularity, with a memory erasable by sector, such as a FLASH memory.

In memories erasable by sector, addresses can be written for a first time but, before a second writing at a same address, it is generally necessary to previously erase the sector comprising the targeted address. If a sector contains both current data and obsolete data, before being able to reuse the addresses which contain the obsolete data, it is thus necessary to perform the saving of the current data, the erasing of the entire sector, and the rewriting of the current data into the sector.

A mechanism is generally implemented to avoid losing the current data in the case where the process of writing of the current data into the sector might not have been completed, for example, if the power supply is cut during the write operation.

However, existing mechanisms impose a significant physical footprint in the circuits as well as a high number of write or erase cycles, accelerating the memory aging.

### Summary of the invention

An embodiment overcomes all or part of the disadvantages of existing solutions.

An embodiment provides a non-volatile memory comprising:
- a plurality of current memory sectors;
- at least one substitution memory sector; and
- a circuit for controlling the non-volatile memory configured to store data into the sectors and to erase data stored in one of the sectors by erasing all the data stored in said sector at once;
a first current memory sector comprising at least one first valid data element and a second current memory sector comprising at least one second valid data element; the memory control circuit being configured to:
- determine that one of the current sectors is to be erased, and accordingly select a sector from among the first and the second current sectors;
- at least copy the valid data of the selected current sector into the substitution memory sector, the substitution memory sector becoming a current sector; and
- erase all the data from the selected current sector, the selected current sector becoming the substitution sector.

Another embodiment provides a non-volatile memory operating method comprising:
- determining, by means of a memory control circuit, that one of the current sectors of a plurality of current memory sectors of the memory is to be erased and accordingly selecting, with the memory control circuit, a sector from among the first and second current sectors, the non-volatile memory control circuit being configured to sequentially store data into the sectors and to erase data stored in one of the sectors by erasing all the data stored in said sector at once, a first current memory sector comprising at least one first valid data element and a second current memory sector comprising at least one second valid data element;
- copying, with the memory control circuit, at least the valid data of the current sector into the substitution memory sector, the substitution memory sector becoming a current sector; and
- erasing, with the memory control circuit, all the data from the selected current sector, the selected current sector becoming the substitution sector.

According to an embodiment, the control circuit is configured to select the current sector having the less space occupied by valid data.

According to an embodiment, an erase counter counts, for each memory sector, a number of times that it is erased, and the control circuit is configured to, if the number counted by the erase counter for one of the memory sectors is greater than a first threshold, copy it into the substitution sector.

According to an embodiment, the largest data element to be written has a first size, the size of each memory sector being greater than or equal to said first size.

According to an embodiment, a space available for writing of the current memory sectors in the plurality, added to a space available for writing of the substitution memory sector, is greater than or equal to the quantity of data to be written into the memory.

According to an embodiment, the plurality comprises a third current memory sector, the memory control circuit being configured to determine that one of the current sectors is to be renewed, and accordingly select a current sector from among the first, second, or third current sectors.

According to an embodiment, the non-volatile memory control circuit is configured to sequentially store data into the sectors.

According to an embodiment, the memory control circuit is configured to only copy the valid data of the selected current sector into the substitution memory sector.

According to an embodiment, the control circuit is configured to select the current sector having a space occupied by valid data that can be contained in the substitution sector.

### Brief description of the drawings

The foregoing features and advantages, as well as others, will be described in detail in the rest of the disclosure of specific embodiments given by way of illustration and not limitation with reference to the accompanying drawings, in which:
Figure 1 schematically shows an example of a non-volatile memory device according to an embodiment of the present disclosure;
Figure 2 schematically shows an example of a data element which is written into an address of the non-volatile memory of Figure 1;
Figure 3 is a simplified view illustrating steps of operation of a non-volatile memory according to an example;
Figure 4 is a simplified view illustrating an example of the operating steps of a non-volatile memory according to an embodiment of the present disclosure;
Figure 5 is a simplified view illustrating another example of the operating steps of a non-volatile memory according to an embodiment of the present disclosure; and
Figure 6 illustrates, in the form of blocks, an operating mode of a non-volatile memory according to an embodiment of the present disclosure.

### Description of the embodiments

Like features have been designated by like references in the various figures. In particular, the structural and/or functional features that are common among the various embodiments may have the same references and may dispose identical structural, dimensional and material properties.

For the sake of clarity, only the steps and elements that are useful for an understanding of the embodiments described herein have been illustrated and described in detail.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, when reference is made to absolute positional qualifiers, such as the terms "front", "back", "top", "bottom", "left", "right", etc., or to relative positional qualifiers, such as the terms "above", "below", "upper", "lower", etc., or to qualifiers of orientation, such as "horizontal", "vertical", etc., reference is made, unless specified otherwise, to the orientation of the figures.

Unless specified otherwise, the expressions "around", "approximately", "substantially" and "in the order of" signify within 10%, and preferably within 5%.

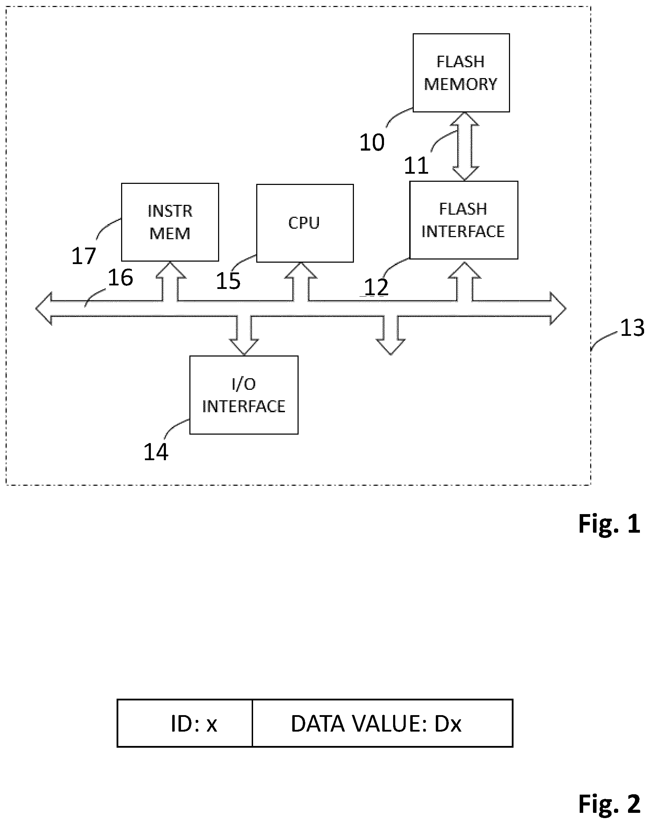

Figure 1 schematically shows an example of a non-volatile memory device 13 according to an embodiment of the present disclosure.

Non-volatile memory device 13 comprises a non-volatile memory 10, for example, of FLASH type (FLASH MEMORY). Non-volatile memory 10 is for example coupled to a system bus of device 13 via a non-volatile memory interface 12 (FLASH INTERFACE). Non-volatile memory interface 12 is coupled, for example, to non-volatile memory 10 via a communication bus 11 and is configured, for example, to particularly ensure the management of the writing and reading of data into and from FLASH memory 10.

Device 13 further comprises, for example, a processing unit 15 (CPU) comprising one or a plurality of processors under control of instructions stored in an instruction memory 17 (INSTR MEM). Instruction memory 17 is for example of random access type (Random Access Memory, RAM). Processing unit 15 and memory 10 communicate, for example, via system bus 16. In an example, device 13 further comprises an input/output interface 14 (I/O INTERFACE) coupled to system bus 16. Although memories 10 and 17 are represented by distinct memory devices, in another example, memories 10 and 17 are implemented by a same memory device. This memory device for example at the same time contains the code to be executed and is further used to store EEPROM-type data.

Memory 10 is a memory divided into a plurality of sectors where data, represented by data elements, are stored. In this type of sector memory, data may be written into empty areas of each sector with a quite low granularity, for example, in words of 16, 32, or 64 bits. However, it is generally not possible to rewrite into an already-programmed area without previously performing the erasing of the area. In certain embodiments, it is however possible to switch bits from state "1" to state "0", however a limited number of times for a same address. Further, since it is not possible to perform the erasing of a portion only of a sector, the erasing operation is applied to an entire sector at once.

Figure 2 is an example of a data element which is for example written into the non-volatile memory 10 of Figure 1. A data element is for example formed of a bit sequence. These bits for example represent a set of a first field comprising an identifier x (ID: x) and of a second field comprising a data value Dx (DATA VALUE: Dx). Data value Dx is for example formed of one or a plurality of bytes having a value that may be updated and the least update of which is searched for when it is accessed to memory 10. Identifier x is for example an integer indicating the identifier of the data value.

In the following, the data elements are represented by Dx_y, where x is the identifier of the data value and where y is an integer indicating an index of the version of the value of the data element. For a data identifier x, -that is, for a fixed x-, the highest index y corresponds to the data element of identifier x which is valid, that is, which is up to date. Index y does not form part, for example, of the data elements stored in non-volatile memory 10, since the valid data element is for example indicated by the order of storage of the data into the memory. Index y does not form part, for example, of the data elements stored in non-volatile memory 10, since the valid data element is for example indicated by the order of storage of the data into the memory.

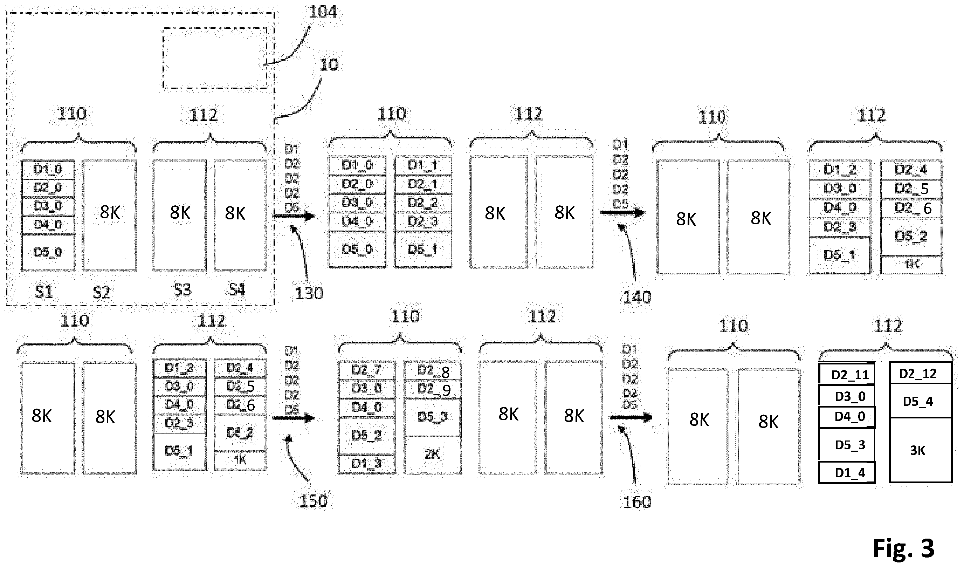

Figure 3 is a simplified view of operating steps of non-volatile memory 10 according to a non-optimal example.

In the example of Figure 3, memory 10 comprises two data banks 110, 112. Bank 110 comprises two memory sectors S1, S2 and data bank 112 comprises two memory sectors S3, S4. In the example of Figure 3, memory sectors S1, S2, S3, S4 each have a 8-kilobyte capacity. In another example, the memory capacity of the sectors is greater than 8 kilobytes, for example, 16 or 32 kilobytes, or event several hundreds or thousands of kilobytes. In still another example, the memory capacity of the sectors is smaller than 8 kilobytes, for example, of 1 kilobyte.

Memory 10 is controlled, for example, by a control circuit 104. In the example of Figure 3, control circuit 104 is contained in memory 10. In another example not illustrated, control circuit 104 is outside of non-volatile memory 10 and forms part, for example, of non-volatile memory interface 12. The circuit 104 for controlling memory 10 is configured to sequentially store data into the sectors, that is, for example, one by one, or two by two, or more generally n by n, where n is a positive integer. Control circuit 104 is also configured to erase the data stored in one of the sectors by erasing all the data stored in the sector at once. In other words, all the data of a sector are erased at once, without it being possible to only erase part of the data of a same sector.

In the example of Figure 3, prior to an operating step 130, data D1_0, D2_0, D3_0, D4_0, and D5_0 are written into sector S1. Sectors S2, S3, S4 are initially empty.

At step 130, data element D1_0 is updated by storing a new data element D1_1, after which data element D2_0 is updated three times by sequentially storing new data elements D2_1, D2_2, and D2_3, and finally data element D5_0 is updated by storing a new data element D5_1. For this purpose, sector S1 being full, the updated data elements D1_1, D2_1, D2_2, D2_3, and D5_1 are written into the next free sector, that is, sector S2. Sector S2 becomes full in turn. Bank 110 is thus full. Sectors S1 and S2 contain valid data: D3_0 and D4_0 for S1, and D1_1, D2_3 and D5_1 for S2.

At a step 140, data element D1_1 is updated by storing a new data D1_2, after which data element D2_3 is updated three times by sequentially storing new data elements D2_4, D2_5 and D2_6 and finally data element D5_1 is updated by storing a new data element D5_2. Sectors S1 and S2, and bank 110, being full, data element D1_2 is stored in sector S3. This storage causes, for example, a switching of banks 110, 112 to be able to keep on storing the updated data. Space should in particular be freed, which implies freeing bank 110. For this purpose, the set of valid data to be stored and those contained in sectors S1 and S2 are copied, that is, transferred, from sectors S1 and S2 to sector S3, and then to sector S4 when sector S3 is full. In the example of Figure 3, after the copying of the valid data and the update of the data in sectors S3 and S4, there remains a non-written space of 1 kilobyte.

At a step 150, data element D1_2 is updated by storing a new data element D1_3, after which data element D2_6 is updated three times by storing new data elements D2_7, D2_8, and D2_9, and finally data element D5_2 is updated by storing a new data element D5_3.

For this purpose, data element D1_3 is written into the 1-kilobyte space remaining free of sector S4. Sector S4 is then full. To be able to write the updated data element D2_7, one has to change bank and write into the sector S1 which has been erased at step 140. The valid data of sectors S3 and S4 are then copied into sector S1, after which bank 112 is erased. The successively updated data elements D2_8, D2_9, and D5_3 are then stored into the remaining space of bank 110, that is, into sector S2. In the example of Figure 2, there then remain 2 free kilobytes in sector S2.

At a step 160, data element D1_3 is updated by storing a new data element D1_4, after which data element D2_9 is updated by storing a new data element D2_10, which is itself updated by storing a new data element D2_11, which is itself updated by storing a new data element D2_12, and finally data element D5_3 is updated by storing the new data element D5_4 .

For this purpose, data element D1_4 and then data element D2_10 are written into the 2-kilobyte space remaining free of sector S2. Sector S2 is then full. To be able to write the updated data element D2_11, one has to change bank and to write into the sector S3 which has been erased at step 150. The valid data of S1 and S2 are then copied into sector S3, after which bank 110 is erased. For this purpose, data element D2_11 is written into sector S3, which has been previously erased at step 150. The valid data of S1 and S2 (that is, D3_0, D4_0, D5_3, and D1_4) are then copied into sector S3, after which bank 110 is erased. The updated data D2_12 and D5_4 are then stored into the remaining space of bank 112, that is, in sector S4. In the example of Figure 3, there then remain 3 free kilobytes in S4.

In the example of Figure 3, data D3_0 and D4_0 are static or nearly, that is, they are not updated often, while data D1, D2, and D5 are regularly updated. In the case where data D3_0 and D4_0 are more bulky than data D1, D2, and D5, the copying of the valid data D3_0 and D4_0 after the memory bank change consumes an energy which should advantageously be limited. Further, this increases the aging of the memory sectors, the total number of the cycles of writing into and erasing from a same sector before this sector becomes defective being limited. To limit these effects, the size of the bank sectors may be increased, but this causes a larger footprint on the circuit, which is costly.

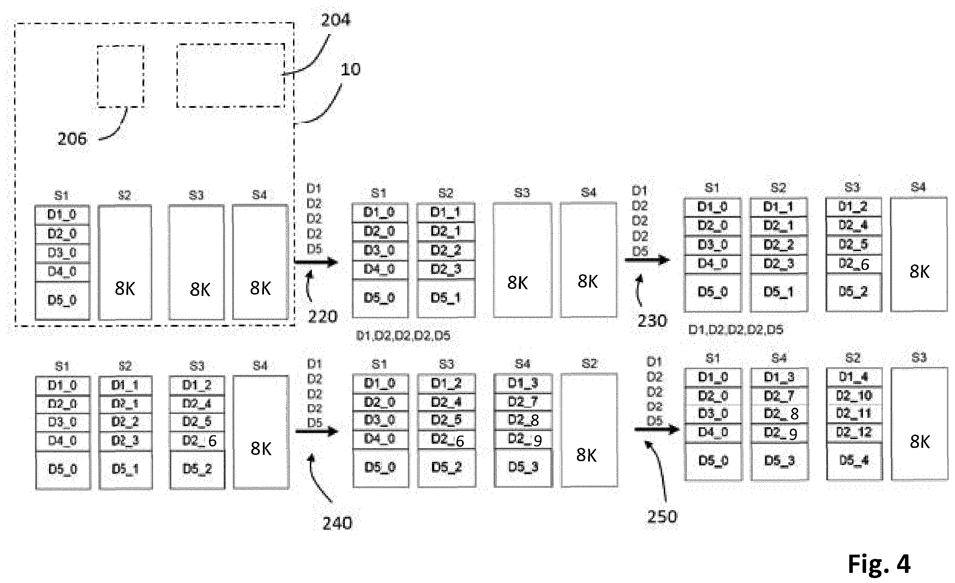

Figure 4 is a simplified view illustrating operating steps of a non-volatile memory 10 according to an embodiment of the present disclosure.

Memory 10 comprises four memory sectors S1, S2, S3, and S4. Sectors S1, S2, S3, and S4 for example each have a storage capacity such as described hereabove in relation with Figure 3.

Memory 10 is controlled, for example, by a control circuit 204. In the example of Figure 4, control circuit 204 is contained in memory 10. In another example, not illustrated, control circuit 104 is outside of non-volatile memory 10 and forms part, for example, of non-volatile memory interface 12. As for the control circuit 104 of Figure 3, the control circuit 204 of memory 10 is configured to sequentially store data into the sectors, that is, for example, one by one, or two by two, or more generally n by n, where n is a positive integer. Control circuit 204 is also configured to erase the data stored in one of the sectors by erasing all the data stored in the sector at once. In other words, all the data of a sector are erased at once without it being possible to only erase part of the data of a same sector.

In the example of Figure 4, prior to an operating step 220, data D1_0, D2_0, D3_0, D4_0, and D5_0 are written into sector S1. Sectors S2, S3, S4 are initially empty. At step 220, sectors S1, S2, and S3 are memory sectors called current sectors and sector S4 is a memory sector called substitution sector.

At step 220, data element D1_0 is updated by storing a new data element D1_1, after which data element D2_0 is updated three times by sequentially storing new data elements D2_1, then D2_2, and D2_3, and finally data element D5_0 is updated and has to be stored. For this purpose, sector S1 being full, the updated data D1_1, D2_1, D2_2, D2_3, and D5_1 are written into the next free sector, that is, sector S2. Sector S2 becomes full in turn. Sectors S1 and S2 then contain the following valid data: D3_0, D4_0 for sector S1 and D1_1, D2_3, D5_1 for sector S2.

At a step 230, data element D1_1 is updated by storing a new data element D1_2, after which data element D2_3 is updated three times by sequentially storing three times new data elements D2_4, D2_5, and D2_6, and finally data element D5_1 is updated by storing a new data element D5_2. For this purpose, sector S2 being full, the updated data D1_2, D2_4, D2_5, D2_6, and D5_2 are written into the next free sector, that is, sector S3. Sector S3 becomes full in turn. Sectors S1 and S3 contain valid data: D3_0, D4_0 for sector S1 and D1_2, D2_6, D5_2 for sector S3. Sector S2 no longer contains valid data.

At a step 240, data element D1_2 is updated by storing a new data element D1_3, then data element D2_6 is updated three times by sequentially storing new data elements D2_7, then D2_8, and D2_9, and finally data element D5_2 is updated by storing a new data element D5_3. For this purpose, the valid data element D1_3 is written into sector S4. The memory control circuit 204 is configured to determine which one among the current memory sectors S1, S2, and S3 is to be erased. In an example, sector S2 is selected since it contains, for example, less valid data than sector S1 or sector S3. Once sector S2 has been selected, only the valid data of sector S2 are copied into the substitution memory sector, that is, sector S4. In the example of Figure 4, sector S2 has no valid data element and thus no data element is copied. All the data of the selected current sector S2 are then erased. The substitution memory sector S4 then becomes a current sector and the selected current sector S2 becomes the substitution memory sector. The updated data D2_7, D2_8, and D2_9 are successively written along their respective update. Then, data element D5_3 is written into sector S4.

At the end of step 240, sectors S1 and S4 contain valid data: D3_0, D4_0 for sector S1 and D1_3, D2_9, D5_3 for sector S4. Sector S3 no longer contains valid data.

At a step 250, data element D1_3 is updated by storing a new data element D1_4, then data element D2_9 is updated by sequentially storing new data elements D2_10, D2_11, and D2_12, and finally data element D5_3 is updated by storing a new data element D5_4. For this purpose, the valid data element D1_4 is written into the substitution sector, that is, S2. The memory control circuit 204 is configured to determine which one among the current memory sectors S1, S3, and S4 is to be erased. In an example, sector S3 is selected since it contains, for example, less valid data than sector S1 or sector S4. Once sector S3 has been selected, at least the valid data of sector S3, if it contains any, are copied into the substitution memory sector, that is, sector S2. In another example not illustrated, once sector S3 has been selected, the valid data elements of sector S3 as well as one or a plurality of non-valid data elements, are copied into substitution memory sector S2. In the example of Figure 4, sector S3 has no valid data and thus none is copied. All the data of the selected current sector S3 are then erased. The substitution memory sector S2 then becomes a current sector and the selected current sector S3 becomes the substitution memory sector. The updated data D2_10, D2_11, and D2_12 are successively written along their respective update in sector S2. Then, data element D5_4 is written into sector S2.

In the example of Figure 4, memory 10 comprises an optional erase counter 206 which counts, for each memory sector, a number of times that it is erased. In this example, control circuit 204 is configured so that, if the number counted by the erase counter for one of the memory sectors is greater than a first threshold, the sector which is determined by control circuit 204 is copied into the substitution sector to then be erased and become the new substitution sector. This enables to average the aging of the sectors in the case where, as in the example of Figure 4, a sector contains static data such as data D3_0 and D4_0. In alternative embodiments, the control circuit 204 is configured to calculate the difference between the numbers counted by two of the erase counters of different sectors, and to compare the calculated difference with a second threshold in order to determine which sector should be designated as the substitution sector. To calculate the difference between the numbers counted by the erase counters, the counter having the lowest number is for example subtracted from the counter having the highest number. For example, the control circuit is configured to determine that a first current memory sector is to become the substitution memory sector if the substitution memory sector has been erased more times than the first current memory sector, and said difference is greater than a second threshold. The second threshold is for example equal to between 1 and 50, and preferably to between 5 and 20.

An advantage of the example of Figure 4 is that the valid data of a sector are not copied if no update occurs thereon. This enables to limit the number of memory write/erase cycles. The optional implementation of the erase counter further enables to improve the aging of the memory sectors by reintroducing into the mechanism an underused sector.

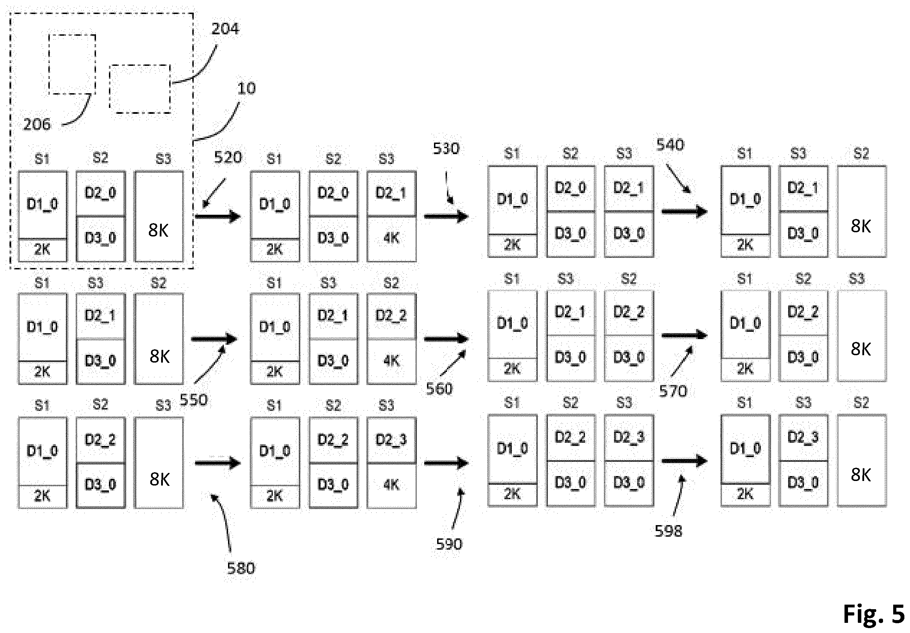

Figure 5 is a simplified view illustrating operating steps of non-volatile memory 10 according to another example of the embodiment of Figure 4 of the present disclosure.

The memory 10 of the example of Figure 5 comprises three memory sectors S1, S2, S3. Sectors S1, S2, and S3 for example each have a storage capacity such as described hereabove in relation with Figure 3.

Memory 10 is coupled to a control circuit 204, which is similar to that described in relation with Figure 4, and will not be described again in detail.

In the example of Figure 5, prior to an operating step 520, a data element D1_0, for example, of 6 kilobytes, is written into sector S1. A data element D2_0, for example, of 4 kilobytes, is written into sector S2 since sector S1 does not have the free space necessary for the writing of data element D2_0. A data element D3_0, for example, of 4 kilobytes, is written into the remaining portion of sector S2. Sector S2 becomes full in turn. Sector S3 is for example initially empty.

At step 520, sectors S1 and S2 are memory sectors called current sectors and sector S3 is a memory sector called substitution sector.

At step 520, data element D2_0 is updated by storing a new data element D2_1. For this purpose, since sectors S1 and S2 do not have the free space necessary for the writing of data element D2_1, data element D2_1 is written into the next free sector, that is, sector S3. Sectors S1 and S2 then contain the following valid data: D1_0 for sector S1 and D3_0 for sector S2.

At a step 530, the control circuit 204 of memory 10 determines which one among the current memory sectors S1 and S2 is to be erased, for example, before storing a new data element D2_2, which is the update of data element D2_1. In the example of Figure 5, sector S2 is selected since all the valid data can be copied into sector S3. More generally, sector S2 is selected since it contains, for example, a smaller quantity of valid data than sector S1, since data element D3_0 is of smaller size than data element D1_0 and data element D2_0 is not valid. Once sector S2 has been selected, only the valid data of sector S2 are copied into the substitution memory sector, that is, sector S3. Data element D3_0 is thus copied into sector S3.

At a step 540, all the data of the selected current sector S2 are then erased. The substitution memory sector S3 then becomes a current sector and the selected current sector S2 becomes the new substitution memory sector.

At a step 550, data element D2_2 is stored. For this purpose, sector S3 being full, data element D2_2 is written into the new substitution sector S2. Sectors S1 and S3 then contain the following valid data: D1_0 for sector S1 and D3_0 for sector S3.

At a step 560, the control circuit of memory 10 determines which one among the current memory sectors S1 and S3 is to be renewed, for example, before being able to store a new data element D2_3, which is the update of data element D2_2. In an example, sector S3 is selected since it contains, for example, a smaller quantity of valid data than sector S1, since data element D3_0 is of smaller size than data element D1_0. Once sector S3 has been selected, only the valid data of sector S3 are copied into the current substitution memory sector, that is, sector S2. Data element D3_0 is thus copied into sector S2.

At a step 570, all the data of the selected current sector S3 are then erased. The substitution memory sector S2 then becomes a current sector and the selected current sector S3 becomes the new substitution memory sector.

At a step 580, data element D2_2 is updated by storing a new data element D2_3. For this purpose, since sectors S1 and S2 do not have the free space necessary for the writing of data element D2_3, data element D2_3 is written into the next free sector, that is, sector S3. Sectors S1 and S2 then contain the following valid data: D1_0 for sector S1 and D3_0 for sector S2.

At a step 590, the control circuit 204 of memory 10 determines which one among the current memory sectors S1 and S2 is to be renewed, for example, before storing the new data element D2_3. In an example, sector S2 is selected since it contains, for example, a smaller quantity of valid data than sector S1, since data element D3_0 is of smaller size than data element D1_0. Once sector S2 has been selected, only the valid data of sector S2 are copied into the current substitution memory sector, that is, sector S3. Data element D3_0 is thus copied into sector S3.

At a step 598, all the data of the selected current sector S2 are then erased. The substitution memory sector S3 then becomes a current sector and the selected current sector S2 becomes the new substitution memory sector.

In the example of Figure 5, memory 10 comprises optional erase counter 206, as described in relation with Figure 4.

An advantage of the example of Figure 5 is that it requires the use of one less sector, for example, three sectors, as compared with the operation which is described in the example of Figure 3 which requires at least the use of four sectors.

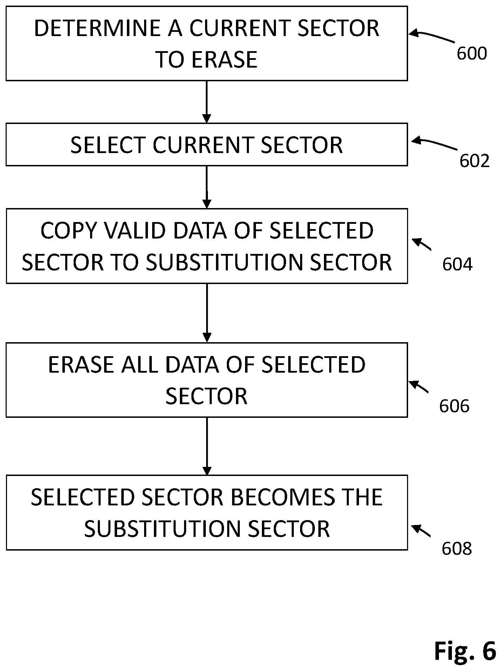

Figure 6 is a block view of an operating method of a non-volatile memory according to an embodiment of the present disclosure. This method is implemented by the control circuit 204 of Figure 4 or of Figure 5.

At a step 600 (DETERMINE A CURRENT SECTOR TO ERASE), it is determined that one of the current sectors is to be erased, for example because there remains no further free space in the current sectors. The current sector to be renewed is determined, for example, by control circuit 204. The current sector to be renewed is for example that having the smallest quantity of valid data.

At a step 602 (SELECT CURRENT SECTOR), the current sector which is to be renewed is selected.

At a step 604 (COPY VALID DATA OF SELECTED SECTOR TO SUBSTITUTION SECTOR), the valid data of the sector selected at step 602 are copied and written into the current substitution sector.

At a step 606 (ERASE ALL DATA OF SELECTED SECTOR), all the data of the current sector which has been selected are erased.

At a step 608 (SELECTED SECTOR BECOMES THE SUBSTITUTION SECTOR), the sector having had its data erased becomes the new substitution sector.

Various embodiments and variants have been described. Those skilled in the art will understand that certain features of these various embodiments and variants may be combined, and other variants will occur to those skilled in the art. In particular, in the examples of Figure 4 or 5, the determination by control circuit 204 of the sector to be renewed is, in an example, independent from the quantity of valid data that the current sectors contain.

In an example, those skilled in the art will understand that the operation of the non-volatile memory may be adjusted by implementing more than one substitution memory sector. For example, the non-volatile memory would have a good performance with more than two current sectors, for example, eight, and two or more substitution sectors.

In another example, those skilled in the art will understand that the operation of the non-volatile memory may be adjusted by partitioning the sectors into a plurality of sections and control circuit 204 will for example be configured to store data in any free section of the selected sector.

In an additional example, in the case where the size of the data is greater than a current sector, for example, equal to two sectors, those skilled in the art will understand that two current sectors could be considered as a "virtual" sector having a double storage capacity and apply the same processes as for Figures 4 and 5. In this case, erasing a virtual sector would imply erasing the two physical sectors forming it.

Furthermore, while embodiments have been described herein in which, when a current sector is to be erased, its contents is copied into the substitution memory sector, it will be apparent to those skilled in the art that, in alternative embodiments, its contents could at least partially be copied into one or more other current memory sectors having available memory space.

Finally, the practical implementation of the described embodiments and variations is within the abilities of those skilled in the art based on the functional indications given hereabove. In particular, the example of Figure 4 is limited to step 250, however, it should be obvious that those skilled in the art can implement a repetition of operations 240 and 250 as many times as necessary during the memory lifetime. Similarly, the example of Figure 5 is limited to step 598, however, it is obvious that those skilled in the art may implement a repetition of operations 520 to 598 as many times as necessary during the memory lifetime.

## Claims

1. Non-volatile memory comprising:
- a plurality of current memory sectors (S1, S2);
- at least one substitution memory sector (S3); and
- a circuit for controlling the non-volatile memory configured to store data into the sectors and to erase data stored in one of the sectors by erasing all the data stored in said sector at once;
a first current memory sector comprising at least one first valid data element (D1_0) and a second current sector comprising at least one second valid data element (D2_0);
the memory control circuit being configured to:
- determine that one of the current sectors is to be erased, and accordingly select a sector from among the first and the second current sectors;
- at least copy the valid data of the selected current sector into the substitution memory sector or into one or more of said current memory sectors, the substitution memory sector becoming a current memory sector; and
- erase all the data from the selected current sector, the selected current sector becoming the substitution sector.

2. Non-volatile memory operating method comprising:
- determining, by means of a memory control circuit, that one of the current sectors of a plurality of current memory sectors (S1, S2) of the memory is to be erased and accordingly selecting, with the memory control circuit, a sector from among the first and second current sectors, the non-volatile memory control circuit being configured to sequentially store data into the sectors and to erase data stored in one of the sectors by erasing all the data stored in said sector at once, a first current memory sector comprising at least one first valid data element (D1_0) and a second current memory sector comprising at least one second valid data element (D2_0) ;
- copying, with the memory control circuit, at least the valid data of the current sector into the substitution memory sector or into one or more of said current memory sectors, the substitution memory sector becoming a current memory sector; and
- erasing, with the memory control circuit, all the data from the selected current sector, the selected current sector becoming the substitution sector.

3. Memory according to claim 1 or method according to claim 2, wherein the control circuit is configured to select the current sector having the less space occupied by valid data.

4. Memory according to claim 1 or method according to claim 2, wherein an erase counter counts, for each memory sector, a number of times that it is erased, and the control circuit is configured to select the current memory sector that is to become the substitution memory sector based on the numbers of times the current and substitution memory sectors have been erased.

5. Memory or method according to claim 4, wherein the control circuit is configured to calculate a difference between the number of times that the substitution memory sector has been erased and the number of times that a first of the current memory sectors has been erased, and to determine that the first current memory sector is to become the substitution memory sector if the substitution memory sector has been erased more times than the first current memory sector, and said difference is greater than a threshold.

6. The memory or method of claim 4, wherein if the number counted by the erase counter for one of the memory sectors is greater than a first threshold, the memory control circuit is configured to copy it into the substitution sector or into one or more of said current memory sectors, and to then erase it, the erased memory sector becoming the new substitution memory sector.

7. Memory according to any of claims 1, or 3 to 6, or method according to any of claims 2 to 6, wherein the largest data element to be written has a first size, the size of each memory sector being greater than or equal to said first size.

8. Memory according to any of claims 1, or 3 to 7 or method according to any of claims 2 to 7, wherein a space available for writing of the current memory sectors in the plurality, added to a space available for writing of the substitution memory sector, is greater than or equal to the quantity of data to be written into the memory.

9. Memory according to any of claims 1, or 3 to 8, or method according to any of claims 2 to 8, wherein the plurality comprises a third current memory sector (S4), the memory control circuit being configured to determine that one of the current sectors is to be renewed, and accordingly select a current sector from among the first, second, or third current sectors.

10. Memory according to any of claims 1, or 3 to 9, or method according to any of claims 2 to 9, wherein the non-volatile memory control circuit is configured to sequentially store data into the sectors.

11. Memory according to any of claims 1, or 3 to 10, or method according to any of claims 2 to 10, wherein the memory control circuit is configured to only copy the valid data of the selected current sector into the substitution memory sector.

12. Memory according to any of claims 1 or 3 to 11, or method according to any of claims 2 to 11, wherein the control circuit is configured to select the current sector having a space occupied by valid data that can be contained in the substitution sector.
